# EUROPEAN PATENT APPLICATION

(11) **EP 4 462 187 A1**
(43) Date of publication of application: **13.11.2024**
(21) Application number: 23172834.6
(22) Date of filing: 11.05.2023
(51) Int. Cl.: G03F 7/00, G02B 5/08

(54) **MIRROR**

(71) Applicant: ASML Netherlands B.V., 5500 AH Veldhoven (NL)
(72) Inventor: THEUNISSEN, Dennie, Deodatus, 5500 AH Veldhoven (NL); NIEUWHOFF, Jordy, 5500 AH Veldhoven (NL); VOORMA, Harm-Jan, 5500 AH Veldhoven (NL); BEEKER, Willem, Paul, 5500 AH Veldhoven (NL)
(74) Representative: ASML Netherlands B.V.

(57) **Abstract**

A mirror (30) comprising a reflective layer (34) supported by a substrate (32), the mirror further comprising a wire (38, 40) which is located between the reflective layer (34) and the substrate (32), wherein the wire (38, 40) includes a plurality of bends such that the wire extends multiple times across the mirror (30), and wherein the wire (38, 40) is configured to break or become non-conducting when a laser beam passes through the reflective layer (34) and is incident upon the wire (38, 40).

## Description

### FIELD

The present invention relates to a mirror. The mirror may form part of a mirror system. The mirror system may form part of a radiation source, which may in turn form part of a lithographic system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus together with an EUV radiation source may be referred to as a lithographic system.

The EUV radiation source may be a laser produced plasma (LPP) system. In an LPP system, a laser beam is used to deposit laser energy into a fuel material. The deposition of laser energy into the fuel material creates a plasma. EUV radiation is emitted from the plasma during de-excitation and recombination of electrons with ions of the plasma.

An LPP system may use two laser beams, a main pulse laser beam and a pre-pulse laser beam, to generate EUV radiation from a fuel material. The pre-pulse laser beam provides some energy into a droplet of fuel material, causing the fuel material to expand. The fuel material may also change shape, e.g. change from spherical to a disk-like shape. The main pulse laser beam is then incident upon the fuel material, generating EUV emitting plasma. An LLP system may use one or more additional laser beams. An additional laser beam may for example be referred to as a rarefaction laser beam.

The pre-pulse laser beam may for example have a wavelength of around 1µm. The main pulse laser beam may for example have a wavelength of around 10µm. The rarefaction laser beam may for example have a wavelength of around 1µm. Other laser beams may be used.

An optical system is used to direct the laser beams into the fuel material. The optical system comprises a plurality of mirrors, and may in addition comprise lenses and other optical elements. The mirrors of the optical system may be used to control a position of the pre-pulse laser beam when it is incident upon the fuel material.

A problem that may arise is that if a mirror of the optical system is damaged such that it no longer properly reflects the pre-pulse laser beam, then laser light may be scattered by the damaged mirror. This scattered laser light may damage other components of the radiation source. The scattered light may also pose a hazard for an operator of the lithographic source. The pre-pulse laser beam may burn through a substrate of a mirror, and pass out of the back of the mirror. As a result, the laser beam may no longer be confined within the lithographic source. Scattering of the laser beam, or the laser beam passing through the mirror substrate, may be particularly problematic for the pre-pulse laser beam of around 1µm, since light of that wavelength may damage the back of a user's eye. The problem may also apply to other laser beams of the radiation source such as the rarefaction laser beam.

### SUMMARY

It is an object of the invention to provide a mirror that overcomes a disadvantage associated with the prior art.

According to a first aspect of the present disclosure there is provided a mirror comprising a reflective layer supported by a substrate, the mirror further comprising a wire which is located between the reflective layer and the substrate, wherein the wire includes a plurality of bends such that the wire extends multiple times across the mirror, and wherein the wire is configured to break or become non-conducting when a laser beam passes through the reflective layer and is incident upon the wire.

Because the wire is located between the reflective layer and the substrate, damage to the reflective layer caused by the laser beam may be detected quickly using the wire, without the laser beam having to first penetrate through the substrate (which would reduce the speed of detection). The wire is provided close to the reflective layer, thereby allowing for quick detection of damage of the reflective layer. Because the wire is broken or becomes non-conductive when the reflective layer is damaged, detected damage to the mirror cannot be wrongly identified as a false detection of damage. A false reset of a system comprising the mirror cannot be performed. The mirror does not include any active components which could fail, such as temperature sensors. This provides the mirror with robustness, making it particularly suitable for applications relating to eye safety of a user.

The wire may extend ten or more times across the mirror.

The wire may extend as straight lines across the mirror.

The bends of the wire may be curved.

The wire may be sandwiched between layers of glass. The wire may be formed from a metal, and insulator provided between portions of the wire may be formed by using a laser beam to cause a chemical change of the metal.

An electrical insulator may be provided between the portions of the wire.

The wire may have a height of less than 100nm.

The wire may be one of two wires. The wires may extend substantially parallel to one another.

The wires may be separated by at least 20µm.

According to a second aspect of the invention there is provided a mirror system comprising the mirror of the first aspect, and further comprising a monitoring system, wherein the monitoring system is configured to monitor the resistance of the or each wire and is configured to provide an output indicating damage to the mirror when the wire or at least one of the wires comprises an open circuit.

The monitoring system may be configured to monitor for a step increase of resistance of the or each wire.

According to a third aspect of the invention there is provided a radiation source comprising a laser configured to emit a laser beam and an optical system comprising a mirror according to the first aspect, wherein the mirror is oriented such that the laser beam is incident on the mirror at an acute angle, wherein the wire is in the form of lines which extend multiple times across the mirror, and wherein the laser beam is elongated in a direction which extends across the lines of wire.

According to a fourth aspect of the invention there is provided a lithographic system comprising the radiation source of the third aspect and further comprising a lithographic apparatus.

According to a sixth aspect of the invention there is provided a method of monitoring for damage of a mirror, the mirror comprising a reflective layer supported by a substrate and a wire which is located beneath the reflective layer and is supported by the substrate, wherein the wire includes a plurality of bends such that the wire extends multiple times across the mirror, wherein the method comprises monitoring a resistance of the wire to detect when the wire breaks or becomes non-conducting due to a laser beam passing through the reflective layer and being incident upon the wire.

The monitoring the resistance of the wire may comprise monitoring for a step increase of the resistance of the wire.

The step increase of the resistance of the wire may comprise a doubling or more of the resistance of the wire.

The step increase of the resistance of the wire may be at least 1kΩ.

The step increase of the resistance of the wire may take place for example in less than one second.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and an EUV radiation source, the EUV radiation source including a mirror according to an embodiment of the present disclosure;
- Figure 2 schematically depicts viewed from above a mirror according to an embodiment of the present disclosure;
- Figure 3 schematically depicts the mirror in cross section;
- Figure 4 schematically depicts in cross-section a laser beam incident upon the mirror;
- Figure 5 schematically depicts viewed from above a laser beam incident upon the mirror; and

Figure 6 schematically depicts in cross-section a mirror according to an alternative embodiment of the present disclosure.

### DETAILED DESCRIPTION

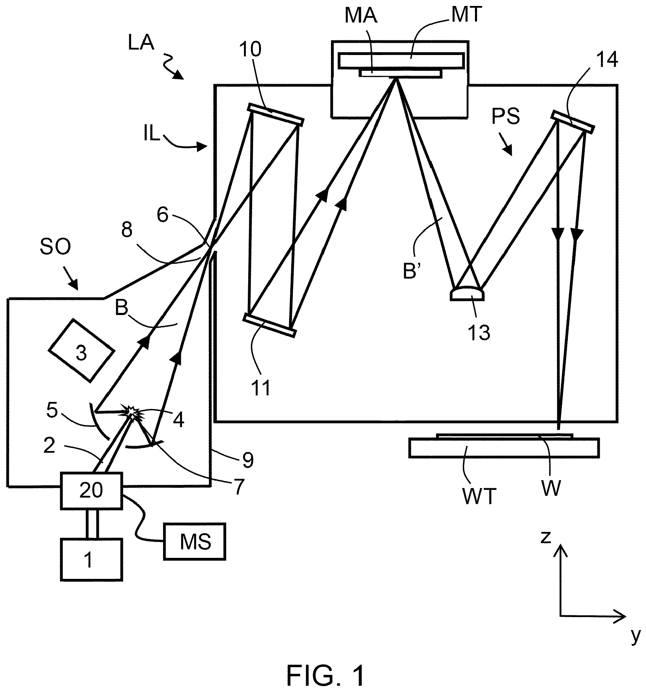

Figure 1 shows a lithographic system which comprises a radiation source SO according to an embodiment of the disclosure, and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1 may comprise a pre-pulse laser system. The pre-pulse laser system may, for example, comprise a Nd:YAG laser (or other laser configured to provide a laser beam with a wavelength of around 1µm). The laser system 1 may include a main-pulse laser system. The main-pulse laser system may, for example, comprise a CO₂ laser (or other laser configured to provide a laser beam with a wavelength of around 10µm). The described embodiment of the present disclosure relate to the pre-pulse laser system. However, other embodiments may relate to other laser systems (which may form part of the radiation source).

The laser system 1 is arranged to deposit energy via a pre-pulse laser beam and a main laser beam (depicted as a single laser beam 2) into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The pre-pulse laser beam 2 is incident upon the tin at the plasma formation region 4. The pre-pulse laser beam provides some energy into the tin, causing the tin to expand. The tin may also change shape, e.g. change from spherical to a disk-like shape. The main pulse laser beam is then incident upon the tin.

The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

An optical system 20 is located between the laser system 1 and the plasma formation region 4. The optical system 20 is configured to control the position of the pre-pulse laser beam 2 such that it is incident upon fuel droplets at the plasma formation region 4. The optical system 20 may also be configured to control properties of the pre-pulse laser beam such that it is focused at the plasma formation region 4.

The optical system 20 comprises a plurality of mirrors, and may in addition comprise lenses and other optical elements. A monitoring system MS receives an output signal from the optical system 20. The output signal depends upon a resistance of a mirror of the optical system 20. The monitoring system MS is configured to monitor for a step increase of the resistance of the mirror, and to provide an output indicating damage to the mirror if a step increase of resistance is occurs. The monitoring system MS and the mirror of the optical system 20 may together be referred to as a mirror system. The optical system 20 forms part of the radiation source SO.

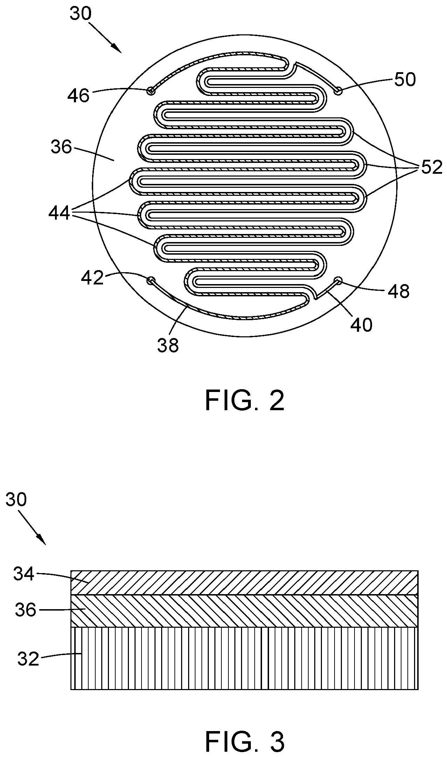

Figures 2 and 3 schematically depict a mirror according to an embodiment of the disclosure.

Figure 2 depicts the mirror 30 viewed from above, and Figure 3 depicts the mirror in cross section. The mirror 30 is part of the optical system 20. The mirror 30 forms part of the optical system 20 used to direct the pre-pulse laser beam 2 to the plasma formation region 4 (see Figure 1). The mirror 30 may be reflective for radiation having a wavelength of around 1µm.

The mirror 30 comprises a substrate 32 and a reflective layer 34. An intermediate layer 36 is provided between the reflective layer 34 and substrate 32. The intermediate layer 36 comprises a pair of wires 38, 40. The intermediate layer may further comprise insulating material which is provided between the wires. The wires 38, 40 are depicted without the insulating material in Figure 2. The wires 38, 40 extend multiple times across the mirror 30. For ease of illustration, the reflective layer 34 is omitted from Figure 2. In practice, the reflective layer 34 may be at least partially transparent to the human eye (although reflective for example at around 1µm). A first wire 38 begins at a contact pad 42. The first wire 38 includes a plurality of bends 44 such that the first wire extends multiple times across the mirror. The first wire 38 ends at another contact pad 46.

In the embodiment of Figure 2 the first wire 38 extends across the mirror 30 fourteen times. However, the first wire may extend across the mirror 30 a different number of times (e.g. ten or more times). In the embodiment of Figure 2 the first wire 38 extends as straight lines across the mirror 30. However, the first wire may be in the form of lines which extend across the mirror 30 with other shapes or forms such as curves. In the embodiment of Figure 2 the bends 44 are in the form of semicircles. However, the bends may have a different shape, e.g. a curved shape. In general, it may be preferable for the bends to be curved rather than being sharp corners. This is because a sharp corner requires the first wire to have additional width, and this additional width will increase the amount of wire which must be broken or become non-conducting in order to trigger an output from the monitoring system MS.

The second wire 40 has an arrangement which generally corresponds with the arrangement of the first wire 38. That is, the second wire 40 includes contact pads 48, 50 and includes bends 52. The second wire 40 also extends as straight lines across the mirror 30. The second wire 40 extends across the mirror 30 fourteen times. Statements above explaining how the first wire 38 may differ from the embodiment of Figure 2 also apply to the second wire 40.

The first and second wires 38, 40 extend parallel to one another. Portions of the wires 38, 40 adjacent to the contact pads 42, 46, 48, 50 do not extend parallel to one another, but instead extend in opposite directions adjacent to a periphery of the mirror 30. In general, the first and second wires 38, 40 extend generally parallel to one another.

There may be a separation of at least 20 microns between the first wire 38 and the second wire 40. There may be a separation of up to 100 microns between the first wire 38 and the second wire 40. At positions where the first wire 38 extends adjacent to itself, the separation between portions of the first wire may be the same as the separation between the first wire and the second wire 40. The separation between portions of the first wire 38 may for example be at least 20 microns, e.g. up to 100 microns. The separation between portions of the second wire 40 may be the same as the separation between the first and second wires 38, 40. The separation between portions of the second wire 40 may for example be at least 20 microns, e.g. up to 100 microns.

The wire separation of at least 20 microns ensures that there is no significant electrical conductance between the first and second wires 38, 40. A wire separation of more than 100 microns may be used. Indeed, any larger wire separation may be used. However, increasing wire separation will reduce detection resolution. That is, if a large wire separation were to be used and the laser burned through the reflective layer 34 between wires then this would not be detected.

The wires 38, 40 may have a thickness which is selected such that ridges formed in the reflective layer 34 due to the wires beneath the reflective layer do not cause significant diffraction of the incident laser beam 2 (see Figure 1). The incident laser beam 2 may for example have a wavelength of around 1 micron. The wires 38, 40 may have a thickness of around 100 nm. This is around 1/10^{th} of the wavelength of the incident laser beam and thus no significant diffraction occurs. Other thicknesses of wires may be used. In this context the term "thickness" is intended to refer to a direction which is normal to the reflective layer 34 of the mirror 30.

The first and second wires 38, 40 may have a width of around 250 microns (e.g. 200 microns or more). In this context the term "width" is intended to refer to a direction which is parallel to the reflective layer 34 of the mirror 30. The width of a wire may be selected such that the wire provides a desired resistance. The resistance of the wire will depend upon the length and the cross-sectional area of the wire. As noted above, order to avoid diffraction, the thickness of the wire may be below a predetermined value based on the wavelength of the incident laser beam. The length of the wire will be determined by the size of the mirror and the number of times that the wire crosses the mirror. Since the length and the thickness of the wire are constrained, it may be preferable to select the width of the wire to provide a desired resistance. A narrower wire will provide higher detection resolution, but will provide higher resistance. The width of the wire may for example be selected such that the resistance of the wire is less than 1kΩ. The wire may for example have a width of 100 microns or more. The wire may have a length of 1m or more.

The substrate 32 may for example be formed from silicon, may be formed from SiSiC, or may be formed from a different material. The substrate may be formed from glass (e.g. fused silica). The substrate may be formed from insulating material. The substrate may be formed from a conducting material such as metal, provided that an insulating layer is present between the conducting material and the wires. However, insulating material is preferable for the substrate because conducting material may cause a short circuit if the wires 38, 40 were to come into contact with the substrate due to melting or other damage. However The substrate may for example have a thickness of around 1 millimeter.

The intermediate layer 36 may comprise the wires 38, 40. Insulating material may be provided between the wires. The wires 38, 40 may for example be formed from copper. A different metal, or other conductor, may be used to form the wires. Insulating material provided in the separations between the first and second wires 38, 40 may for example be silicon oxide, or a different oxide. If the reflective layer 34 is insulating, then the insulating material may comprise the reflective layer. If the reflective layer 34 has an insulating lowermost surface, then the insulating material may comprise the lowermost surface of the reflective layer.

In use, the monitoring system MS monitors the resistance of the first wire 38 and the resistance of the second wire 40. The resistance of each wire 38, 40 may for example be less than 1kΩ. If the reflective layer 34 of the mirror 30 is damaged such that it no longer properly reflects the laser beam 2, then the laser beam 2 will pass through the reflective layer and will be incident upon both of the wires 38, 40. The laser beam 2 will burn through, melt or ablate the wires 38, 40 such that the wires are broken. There are now two opens circuit. The monitoring system MS will detect these as a step increase in the resistance of the wires 38, 40. The resistance when the wires 38, 40 are broken may for example be greater than 2kQ (for each wire). In general, a step increase of wire resistance of at least 1kΩ may occur. When the resistance of the wires 38 steps upwards in this way, the monitoring system MS generates an output which indicates that the mirror 30 has been damaged. This may cause the laser 1 to switch off, or a shutter to be closed, or the laser beam 2 to be diverted to a beam-dump. In general, action is taken such that the laser beam 2 is no longer incident upon the mirror 30. This prevents laser radiation being scattered from the mirror 30 and damaging other components, or burning fully through the mirror and damaging components behind the mirror. If the mirror 30 is in a location where scattered light may be incident upon an eye of a user, this also prevents potential injury to the user.

The two wires 38, 40 provide redundancy when detecting damage to the reflective layer 34. For example, one of the wires may connect to a melted conducting portion of the reflective layer 34. This may cause a short circuit, meaning that a step increase of resistance is not seen by the monitoring system MS for that wire. If this happens then a step increase of resistance will be seen for the other wire, meaning that the damage to the reflective layer is still detected by the monitoring system MS.

The separation between the first and second wires 38, 40 may be selected with reference to the size of a potential area of damage on the mirror 30 such that both the first and second wires are likely to be broken if the mirror 30 is damaged. Consequently, the monitoring system MS will see a step increase of the resistance of the first wire 38 and a step increase of the resistance of the second wire 40 if the mirror 30 is damaged. This provides redundancy and thus increases the safety provided by the mirror system.

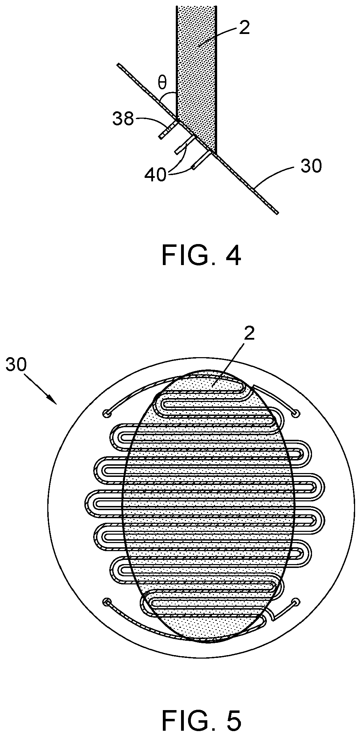

The separation between the wires 38, 40 may for example be around 20 microns or more. The wires may for example have a thickness of around 250 microns. Where this is the case, if both wires 38, 40 must be broken in order to trigger detection by the monitoring system MS, then one of the wires will need to be broken twice (due the configuration of the wires). This means that an area of damager should measure around 800 microns or more (3x 250 microns plus 2x20 microns) in a direction transverse to the wires in order to ensure that the damage is detected. This applies for a normal or close to normal incident laser beam. In practice, an area of damage of the mirror 30 is likely to be wider than the laser beam diameter, and so damage caused by a laser beam having a diameter of less than 800 microns may be detected. When the laser beam is incident at an acute angle, then a narrower laser beam may be detected for a given wire separation, as explained below in connection with Figure 4. In practice, the laser beam 2 may for example have a diameter of at least 2mm. The laser beam 2 may for example have a diameter of up to 8mm.

Figure 4 schematically depicts the laser beam 2 being incident upon the mirror 30. Only a small portion of the mirror 30 is depicted, the mirror being depicted in cross section with the first wire 38 and the second wire 40 being schematically depicted. One portion of the first wire 38 is depicted, and two portions of the second wire 40. As may be seen in Figure 4, the laser beam 2 is incident on the mirror 30 at an acute angle θ. The wires 38, 40 extend generally perpendicular to the incident laser beam 2. In the depicted embodiment the wires 38, 40 extend into the plane of Figure 4. The orientation of the wires 38, 40 is such that the laser beam 2 is elongated in a direction which is generally perpendicular to the direction in which the wires extend (i.e. across lines of the wire). This arrangement advantageously ensures that the laser beam 2 is incident over more portions of wire 38, 40 than would be the case if for example the wires extended in a different direction (e.g. in a plane which is generally parallel to the incident laser beam). As depicted, the laser beam is incident upon one portion of the first wire 38, and two portions of the second wire 40. If mirror 30 was rotated by 90° then the laser beam would be elongated along the wires instead of across the wires, and would be upon only one portion of each of the wires 38, 40.

In the optical system 20 different portions of the laser beam may have different diameters. Figure 5 schematically depicts a functional area of the mirror 30. That is an area of the mirror that can reflect the laser beam and that will reliably detect damage of the reflective layer 34. The functional area is elongated in a direction which extends across the wires 38, 40 (and not in a direction which extends along the wires).

In some embodiments, a bonding layer (not depicted) may be located between the wires 38, 40 and the substrate 32. The bonding layer may for example be formed from chromium. The bonding layer may for example have a thickness of around 5 nanometers.

In some embodiments an insulation layer (not depicted) may be provided above the wires 38, 40 and below the reflective layer 34. This may be the case for example if a lowermost surface of the reflective layer 34 is conducting.

The reflective layer 34 may for example comprise a tantalum oxide high reflection coating. The reflective layer 34 may comprise a multi-layer structure, formed from alternating layers of materials with different refractive indexes. Such a multi-layer structure may be referred to as a multi-layer mirror.

In embodiments of the invention described above, the wire or wires 38, 40 are broken by the laser beam when the reflective layer 34 is damaged. Breaking the wires may for example comprise burning away, melting or ablating the wires. The wires 38, 40 may be referred to as fuse wires.

In embodiments of the invention described above, two wires 38, 40 are provided. However, a single wire may be used. Wire properties described above in connection with two wires may also apply for a single wire embodiment. More than two wires may be used.

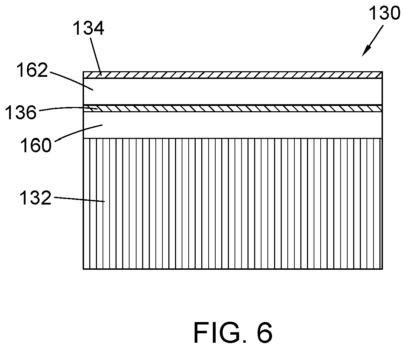

An alternative embodiment of the disclosure is schematically depicted in Figure 6. Figure 6 depicts in cross-section part of a mirror 130 according to an embodiment. The mirror 130 comprises a substrate 132, an intermediate layer 136 and a reflective layer 134. A first layer of glass 160 is located between the substrate 132 and the intermediate layer 136. A second layer of glass 162 is located between the intermediate layer 136 and the reflective layer 134. The glass layers 160, 162 may for example be formed from borofloat BF33. The layers of glass 160, 162 may for example have a thickness of around 200 microns. Other thicknesses may be used.

The substrate 132 may be formed from SiSiC. The substrate may be formed from silicon. The substrate 132 may be formed from any suitable material including for example glass (e.g. fused silica). The substrate may be formed from an insulating material. The substrate 132 may be formed from metal (e.g. copper or aluminium), although in that case an insulating structure would be needed to ensure that a broken wire does not form a conductive bridge via the metal substrate.

The intermediate layer 136 comprises first and second wires (not depicted). Each wire includes a plurality of bends such that the wire extends multiple times across the mirror. The wires may be provided in an arrangement that corresponds with the arrangement depicted in Figure 2.

The wires are formed from copper. An insulator located between the wires is formed from copper which has undergone a chemical change. The wires are formed by providing a layer of copper between the glass layers 160, 162. A "writing" laser is then directed through the second layer of glass 162 onto the copper layer 136 at locations where insulating material is desired. The writing laser causes a local chemical change of the copper which convert the copper to an insulator. The insulator may be copper oxide. Thus, the writing laser forms insulating areas. The writing laser is moved over the copper layer 136 such that insulator is formed at all locations where insulator is required. Locations which do not receive the writing laser are not changed to insulator, but instead remain as copper. In this way, two copper wires are formed which are separated by insulator (which may be copper oxide). This writing process may be referred to as post-bonding structuring (PBS).

The reflective layer 134 may be provided upon the second glass layer 162 after the wires have been formed. In other embodiments, the reflective layer 134 may be provided upon the second glass layer 162 before the writing laser is used (provided that the reflective layer is substantially transparent to the writing laser and will not be damaged by the writing laser).

In use, when the reflective layer 134 is damaged by an incident laser beam 2, the incident laser beam will pass through the reflective layer and will be incident upon the copper wires. Portions of the copper wires upon which the laser beam is incident will undergo a chemical change and convert to insulator. These portions are non-conducting. As a result, open circuits are formed. The open circuits are detected by the monitoring system MS, which provides an output indicating damage to the mirror. The monitoring system MS monitors for a step increase of the resistance of the wires in the same manner as was described further above in connection with the first embodiment. The chemical change may take place before melting/ablation of the wires. Consequently, detection of damage will take place particularly quickly.

The laser beam 2 will melt/ablate the copper wires. This will take place after the chemical change. If for any reason the chemical change does not take place, then open circuits will be formed by the melting/ablating of the copper wires, and the monitoring system will detect a step increase of resistance when this happens.

An advantage of the embodiment of Figure 6 is that because the copper wires are sandwiched between layers of glass 160, 162, the copper wires are changed to copper oxide when the laser beam is incident upon them. The copper wires do not burn. As a result, no smoke, vapor or other potential contaminants are released from the mirror 130.

A further advantage of the embodiment of Figure 6 is that forming the copper wires and insulator does not create a ridged structure (unlike the embodiment of Figures 2-5). The reflector 134 thus does not have a ridged structure. This means that forming the copper wires and insulator will not cause diffraction of the incident laser beam. Consequently, the thickness of the copper wires may be larger than for the embodiment of Figures 2-5 without causing diffraction of the incident laser beam.

Aspects of other embodiments described further above may also apply for the embodiment of Figure 6. Thus, for example, the embodiment may be provided with a single wire. The wire may extend across the mirror 130 ten or more times. The wire may extend as straight lines across the mirror 130. The wire may be in the form of lines which extend across the mirror 130 with other shapes or forms such as curves. Bends of the wire may be in the form of semicircles. The bends may have a different shape, e.g. a curved shape. In general, it may be preferable for the bends to be curved rather than being sharp corners.

The wire may have a thickness of up to around 200 nm (it may be difficult to make a thicker structure using the "writing" process). Other thicknesses of wires may be used.

The embodiment may be provided with two wires. Where this is the case, the above may apply for both wires.

Values width, length and separation values for the wires may be as set out above in connection with Figures 2 to 4. There may be a separation of at least 20 microns between the two wires. The wire or wires may have a width of at least 200 microns..

The wire or wires may extend generally perpendicular to the incident laser beam 2. The incident laser beam may be elongated in a direction which extends across the wire or wires. The wire or wires are in the form of lines, and the laser beam is elongated in a direction which extends across the lines of wire.

In an embodiment, aluminium may be used instead of copper. Other metal may be used.

In all embodiments the wire or wires are located beneath the reflective layer.

In all embodiments the wire or wires are supported by the substrate. This does not mean that the wire or wires must be in contact with the substrate. As noted above, a bonding layer may for example be provided between the wire or wires and the substrate.

A mirror according to an embodiment of the disclosure, when combined with a monitoring system may be referred to as a mirror system.

An optical system of the radiation source may comprise more than one mirror according to an embodiment of the disclosure. More than one mirror may be connected to the monitoring system. The monitoring system may monitor each mirror independently.

A step increase of resistance which is detected by the monitoring system may for example be a doubling or more of the resistance. The step increase of resistance may be an increase of at least 1kΩ. The step increase of resistance may take place for example in less than one second.

### Clauses

1. A mirror comprising a reflective layer supported by a substrate, the mirror further comprising a wire which is located between the reflective layer and the substrate, wherein the wire includes a plurality of bends such that the wire extends multiple times across the mirror, and wherein the wire is configured to break or become non-conducting when a laser beam passes through the reflective layer and is incident upon the wire.
2. The mirror of clause 1, wherein the wire extends ten or more times across the mirror.
3. The mirror of any preceding clause, wherein the wire extends as straight lines across the mirror.
4. The mirror of any preceding clause, wherein the bends of the wire are curved.
5. The mirror of any preceding clause, wherein the wire is sandwiched between layers of glass, wherein the wire is formed from a metal, and wherein insulator provided between portions of the wire is formed by using a laser beam to cause a chemical change of the metal.
6. The mirror of any preceding clause, wherein an electrical insulator is provided between the portions of the wire.
7. The mirror of any preceding clause, wherein the wire has a height of less than 100nm.
8. The mirror of any preceding clause, wherein the wire is one of two wires, and wherein the wires extend substantially parallel to one another.
9. The mirror of clause 8, wherein the wires are separated by at least 20µm.
10. A mirror system comprising the mirror of any preceding clause, and further comprising a monitoring system, wherein the monitoring system is configured to monitor the resistance of the or each wire and is configured to provide an output indicating damage to the mirror when the wire or at least one of the wires comprises an open circuit.
11. The mirror system of clause 10, wherein the monitoring system is configured to monitor for a step increase of resistance of the or each wire.
12. A radiation source comprising a laser configured to emit a laser beam and an optical system comprising a mirror according to any preceding clause, wherein the mirror is oriented such that the laser beam is incident on the mirror at an acute angle, wherein the wire is in the form of lines which extend multiple times across the mirror, and wherein the laser beam is elongated in a direction which extends across the lines of wire.
13. A lithographic system comprising the radiation source of clause 12, and further comprising a lithographic apparatus.
14. A method of monitoring for damage of a mirror, the mirror comprising a reflective layer supported by a substrate and a wire which is located beneath the reflective layer and is supported by the substrate, wherein the wire includes a plurality of bends such that the wire extends multiple times across the mirror, wherein the method comprises monitoring a resistance of the wire to detect when the wire breaks or becomes non-conducting due to a laser beam passing through the reflective layer and being incident upon the wire.
15. The method of clause 14, where in the monitoring the resistance of the wire comprises monitoring for a step increase of the resistance of the wire.
16. The method of clause 14, where the step increase of the resistance of the wire comprises a doubling or more of the resistance of the wire.
17. The method of clause 15 or clause 16, wherein the step increase of the resistance of the wire is at least 1kΩ.
18. The method of any of clauses 15 to 16, where the step increase of the resistance of the wire takes place for example in less than one second.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.
While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A mirror comprising a reflective layer supported by a substrate, the mirror further comprising a wire which is located between the reflective layer and the substrate, wherein the wire includes a plurality of bends such that the wire extends multiple times across the mirror, and wherein the wire is configured to break or become non-conducting when a laser beam passes through the reflective layer and is incident upon the wire.

2. The mirror of claim 1, wherein the wire extends ten or more times across the mirror.

3. The mirror of any preceding claim, wherein the wire extends as straight lines across the mirror.

4. The mirror of any preceding claim, wherein the bends of the wire are curved.

5. The mirror of any preceding claim, wherein the wire is sandwiched between layers of glass, wherein the wire is formed from a metal, and wherein insulator provided between portions of the wire is formed by using a laser beam to cause a chemical change of the metal.

6. The mirror of any preceding claim, wherein an electrical insulator is provided between the portions of the wire.

7. The mirror of any preceding claim, wherein the wire has a height of less than 100nm.

8. The mirror of any preceding claim, wherein the wire is one of two wires, and wherein the wires extend substantially parallel to one another.

9. The mirror of claim 8, wherein the wires are separated by at least 20µm.

10. A mirror system comprising the mirror of any preceding claim, and further comprising a monitoring system, wherein the monitoring system is configured to monitor the resistance of the or each wire and is configured to provide an output indicating damage to the mirror when the wire or at least one of the wires comprises an open circuit.

11. The mirror system of claim 10, wherein the monitoring system is configured to monitor for a step increase of resistance of the or each wire.

12. A radiation source comprising a laser configured to emit a laser beam and an optical system comprising a mirror according to any preceding claim, wherein the mirror is oriented such that the laser beam is incident on the mirror at an acute angle, wherein the wire is in the form of lines which extend multiple times across the mirror, and wherein the laser beam is elongated in a direction which extends across the lines of wire.

13. A lithographic system comprising the radiation source of claim 12, and further comprising a lithographic apparatus.

14. A method of monitoring for damage of a mirror, the mirror comprising a reflective layer supported by a substrate and a wire which is located beneath the reflective layer and is supported by the substrate, wherein the wire includes a plurality of bends such that the wire extends multiple times across the mirror, wherein the method comprises monitoring a resistance of the wire to detect when the wire breaks or becomes non-conducting due to a laser beam passing through the reflective layer and being incident upon the wire.

15. The method of claim 14, where in the monitoring the resistance of the wire comprises monitoring for a step increase of the resistance of the wire.
